# EUROPÄISCHE PATENTSCHRIFT

(11) **EP 1 663 852 B1**
(45) Veröffentlichungstag und Bekanntmachung des Hinweises auf die Patenterteilung: **31.12.2008**
(21) Anmeldenummer: 04738871.5
(22) Anmeldetag: 07.07.2004
(51) Int. Cl.: B81C 1/00

(54) **Verfahren zum Vereinzeln von Bauteilen**
Method for singulating devices
Procédé d'individualisation de composants

(30) Priorität: 12.09.2003 DE 10342155
(43) Veröffentlichungstag der Anmeldung: 07.06.2006
(73) Patentinhaber: ROBERT BOSCH GMBH, 70442 Stuttgart (DE)
(72) Erfinder: RUDHARD, Joachim, 70771 Leinfelden-Echterdingen (DE)
(86) Internationale Anmeldenummer: PCT/DE2004/001449
(87) Internationale Veröffentlichungsnummer: WO 2005/026041

(56) Entgegenhaltungen:
- DE-A- 10 102 993
- US-A- 5 961 877
- US-B1- 6 198 098
- US-B1- 6 210 988
- TILLACK B ET AL: "MONITORING OF DEPOSITION AND DRY ETCHING OF SI/SIGE MULTIPLE STACKS" JOURNAL OF VACUUM SCIENCE AND TECHNOLOGY: PART B, AMERICAN INSTITUTE OF PHYSICS. NEW YORK, US, Bd. 14, Nr. 1, 1996, Seiten 102-105, XP000198643 ISSN: 1071-1023
- PREMACHANDRAN C S ET AL: "A novel electrically conductive wafer through hole filled vias interconnect for 3D MEMS packaging" 2003 PROCEEDINGS 53RD. ELECTRONIC COMPONENTS AND TECHNOLOGY CONFERENCE. (ECTC). NEW ORLEANS, LA, MAY 27 - 30, 2003, PROCEEDINGS OF THE ELECTRONIC COMPONENTS AND TECHNOLOGY CONFERENCE, NEW YORK, NY : IEEE, US, Bd. CONF. 53, 27. Mai 2003 (2003-05-27), Seiten 627-630, XP010648307 ISBN: 0-7803-7991-5

## Beschreibung

Die Erfindung betrifft ein Verfahren zum Vereinzeln von auf Silizium bzw. einem Schichtaufbau Silizium/Isolator basierenden Bauteilen nach dem Oberbegriff des Anspruchs 1.

### Stand der Technik:

In der Halbleitertechnik gibt es eine Reihe von Anwendungen, bei welchen Ätzlöcher bzw. Ätzgräben vergleichsweise tief in ein Substrat hinein, z.B. in einen Wafer hinein oder gegebenenfalls vollständig durch das Substrat hindurch, erzeugt werden müssen. Insbesondere ein vollständiges Durchdringen z.B. eines Wafers ist bei den meisten Prozessen nicht ohne weiteres möglich.

Bekannt ist ein Verfahren, bei welchem ein Siliziumwafer von der Rückseite an den Stellen, an denen ein durchgehender Graben oder ein Durchgangsloch entstehen soll, bis zu einer vorgegebenen unkritischen Tiefe z.B. mit Hilfe eines KOH-Ätzprozesses geätzt wird. Anschließend werden die entstandenen Ätzstrukturen mit einem Lack, z.B. Fotolack aufgefüllt. Im Weiteren kann von der Vorderseite problemlos der durchgehende Graben oder das Durchgangsloch in den Wafer geätzt werden, wobei der Lack als Ätzstopp dient und zugleich verhindert, dass Ätzmedium durch den Wafer hindurch auf die Rückseite des Wafers in einen entsprechenden Bereich der Prozessanlage bzw. die Waferklemmvorrichtung gelangen kann und dadurch der Prozess gestoppt wird bzw. die entsprechenden Einheiten verunreinigt werden.

Eine solche Vorgehensweise ist jedoch vergleichsweise aufwendig. Denn bei der Strukturierung der Wafer-Rückseite muss gleichzeitig die Vorderseite vor Beschädigungen geschützt werden. Zudem ist ein gesonderter Lackaufbringungsschritt für das Auffüllen der auf der Rückseite entstandenen Vertiefungen notwendig.

### Aufgabe und Vorteile der Erfindung:

Der Erfindung liegt die Aufgabe zugrunde, ein Verfahren zum Vereinzeln von Bauelementen anzugeben.

Diese Aufgabe wird durch die Merkmale des Anspruchs 1 gelöst.

In den Unteransprüchen sind vorteilhafte und zweckmäßige Weiterbildungen der Erfindung angegeben.

Die Erfindung geht zunächst von einem Verfahren zur Herstellung von Ätzlöchern und/oder Ätzgräben von auf Silizium bzw. einem Schichtaufbau Silizium/Isolator basierenden Bauteilen aus. Der Kern der Erfindung liegt nun darin, dass eine germaniumhaltige Schicht und/oder eine Germaniumschicht an der Stelle vorgesehen wird, an welcher oder in deren Umgebung ein Ätzvorgang im Silizium bzw. einem Isolator beendet werden soll, dass während des Ätzvorgangs auf Germanium- und/oder Germaniumverbindungen eine Detektion durchgeführt wird und dass in Abhängigkeit von der Detektion von Germanium und/oder Germaniumverbindungen der Ätzvorgang gesteuert, insbesondere abgebrochen wird. Dieser Vorgehensweise liegt die Erkenntnis zugrunde, dass sich Germanium bzw. Germaniumverbindungen in einem Ätzvorgang vergleichsweise gut in Bezug auf Ätzprodukte bei der Ätzung von Silizium oder im Halbleiterbereich üblicherweise eingesetzten Isolatoren detektieren lässt. Zur Detektion von Germanium oder Germaniumverbindungen kann ein Massenspektrometer oder ein optisches Emissionsspektrometer, z.B. zur Auswertung eines Ätzplasmas eingesetzt werden.

Ein solches Verfahren ist in Tillack B. et al: "Monitoring of deposition and dry etching of Si/SiGe multiple stacks" Journal of Vacuum Science and Technology: Part B, American Institute of Physics. New York, USA, Bd. 14, Nr. 1, 1996, Seiten 102-105, offenbart.

Beispielsweise wird in einem Ätzplasma basierend auf Fluor-Chemie mit einem optischen Emissionsspektrometer nach dem Auftreten einer GeFₓ-Linie überwacht, um das Erreichen einer Germanium- bzw. germaniumhaltigen Schicht feststellen zu können. Das Auftauchen einer diesbezüglichen Linie im Spektrum kann als "Stoppkriterium" für den Ätzprozess eingesetzt werden, nämlich dann, wenn entsprechende Ätzgräben oder Ätzlöcher bis zu der entsprechenden Germanium- bzw. germaniumhaltigen Schicht in z.B. einen Wafer eingebracht werden sollen.

Im erfindungsgemäßen Verfahren wird auf der Rückseite eines Siliziumwafers die Germanium- und/oder germaniumhaltige Schicht aufgebracht. Durch diese Maßnahme kann mit üblichen Plasmaätzprozessen ein Ätzgraben (Trench) durch den kompletten Wafer hindurch geätzt werden, wobei mit der Detektion von Germaniumätzprodukten das vollständige Durchätzen durch den Wafer leicht festgestellt werden kann. In diesem Moment wird der Ätzvorgang gestoppt, so dass auf die Rückseite des Wafers nach wie vor kein vollständiger Durchgang vorhanden ist. Vielmehr stellt die Germaniumschicht eine Schutzbarriere dar, so dass kein Ätzmedium z.B. zu einer Waferklemmvorrichtung auf der Rückseite des Wafers gelangen kann bzw. eine Halterung des Wafers z.B. mit einem Vakuumchuck nach wie vor möglich ist.

Nach Beendigung des Ätzvorgangs bis zur Germanium- und/oder germaniumhaltigen Schicht wird diese vollständig entfernt. Eine Germaniumschicht oder eine germaniumhaltige Schicht lässt sich beispielsweise selektiv zu Silizium bzw. gängigen in der Halbleitertechnik eingesetzten Isolatoren mit Hilfe von Wasserstoffperoxid oder wasserstoffperoxidhaltigen Ätzlösungen entfernen.

Eine Germanium- bzw. germaniumhaltige Schicht z.B. eine germaniumhaltige Siliziumschicht (SiGe) kann mittels CVD (Chemical Vapor Deposition) oder PECVD (Plasma Enhanced Chemical Vapor Deposition) abgeschieden werden, sofern dies sich mit dem Gesamtprozess, insbesondere vorangehenden Prozessschritten verträgt. Eine Germanium- oder germaniumhaltige Schicht kann auch aufgesputtert werden, was bei vergleichsweise geringeren Temperaturen möglich ist. Bei einer Schichterzeugung mittels Sputtern besteht außerdem die Möglichkeit, eine Germanium- bzw. germaniumhaltige Schicht mit weiteren Schichten in einem vorteilhaften Schichtsandwich zu kombinieren. Beispielsweise kann die Germanium- bzw. germaniumhaltige Schicht mit einer Metalldeckschicht, wie z.B. Wolfram-Titan versehen werden. Dies hat Vorteile im Hinblick auf eine Kontaminationsprävention.

Die auf der Rückseite eines Wafers angebrachte Germanium- und/oder germaniumhaltige Schicht wird für die Vereinzelung von elektronischen Bauteilen aus dem Wafer vorteilhaft eingesetzt werden, indem im Wafer bis zur Germaniumschicht vollständig durchdringende Gräben erzeugt werden und in einem nachfolgenden Schritt die Germaniumschicht entfernt wird, wodurch Einzelbauteile entsprechend der Ätzgräben entstehen, da ein Zusammenhalt durch die rückseitige Germanium- und/oder germaniumhaltige Schicht nach deren Entfernung nicht mehr gegeben ist.

In einem nicht zur Erfindung gehörenden Verfahren kann auch die Germanium- und/oder germaniumhaltige Schicht in einem Schichtaufbau vergraben werden. In diesem Aufbau kann die Germanium- und/oder germaniumhaltige Schicht gezielt als "Ätzstopp"-Schicht eingesetzt werden, indem bei Ätzvorgängen in einer darüber angeordneten Schicht bzw. mehreren darüber angeordneten Schichten (die kein Germanium enthalten) nach Germanium- bzw. Germaniumverbindungen detektiert wird. Auf diese Weise können z.B. "Trench-Ätz-Prozesse" oder Ätzprozesse zur Erzeugung einer Kaverne definierter vorgenommen werden.

Diese Vorteile lassen sich insbesondere bei einer Membransensoreinheit mit einem Träger aus Silizium oder einem Schichtaufbau Silizium/Isolator, die zur Ausbildung einer Sensorelementstruktur für einen Sensor eine flächige Membran umfasst, erzielen, wenn erfindungsgemäß im Schichtaufbau eine Germanium- und/oder germaniumhaltige Schicht vorgesehen ist.

Eine vergrabene Germanium- und/oder germaniumhaltige Schicht im Schichtaufbau kann gleichzeitig als eine Bauteilfunktionsschicht benutzt werden. Beispielsweise lässt sich diese Schicht als Membran einsetzen, die in einem oder mehreren Ätzprozessen durch Entfernen von angrenzendem Material, wie z.B. Silizium oder siliziumhaltigen Oxiden entsteht. Ein solcher Vorgang ist durch die vergleichsweise exakte Detektierbarkeit des Erreichens der Germanium- und/oder germaniumhaltigen Schicht zuverlässig möglich.

Prinzipiell kann eine Germanium- und/oder germaniumhaltige Schicht für die Kontrolle eines lateralen und/oder vertikalen Ätzprozess auf einem Substrat zur Anwendung kommen.

### Zeichnungen:

Ein Ausführungsbeispiel der Erfindung ist unter Angabe weiterer Vorteile und Einzelheiten anhand der nachfolgenden Zeichnungen beschrieben. Es zeigen
- Figur 1 bis 6: in schematischen Schnittbildern sechs Prozessstadien eines auf wesentliche Schritte vereinfachten Prozesslaufs am Beispiel der Herstellung eines piezoresistiven Kraftaufnehmers in SOI (Silicon On Isolator)-Technik.

In Figur 1 ist im Schnitt ein SOI-Wafer 1 dargestellt. Der SOI-Wafer 1 besteht aus Funktionssilizium 2 und einer SOI-Oxid-Schicht 3 auf Bulksilizium 4.

In Figur 2 ist der Schichtaufbau nach der Strukturierung des Funktionssiliziums 2 in Teilbereiche 2a mit Hilfe einer Fotolackmaske 5 durch einen anisotropen Ätzprozess gezeigt. Die Funktionsschicht 2 wurde bis zur SOI-Oxidschicht 3 getrencht (durchgeätzt).

Figur 3 zeigt ein Prozessstadium nach folgenden Schritten:

Die Lackmaske 4 wurde entfernt. Zwischen den Funktionssiliziumbereichen 2a wurden mit einem Fülloxid 6 die "getrenchten" Bereichen 7 aufgefüllt und das Fülloxid 6 in Kontaktbereichen 8 über einen weiteren Masken/Fotolithografieschritt wieder geöffnet. In zwei nachfolgenden Sputterschritten wurden zum einen die Metallisierung für die Kontakte 8 auf der Vorderseite und zum anderen eine Germaniumschicht 9 auf der Rückseite des Wafers 1 aufgesputtert. Über einen weiteren Masken/Fotolithografieprozess wurde die Kontaktebene in einem z.B. Metalltrockenätzprozess strukturiert. Als Resultat dieser Prozessreihe verbleibt das strukturierte Kontaktmetall 8.

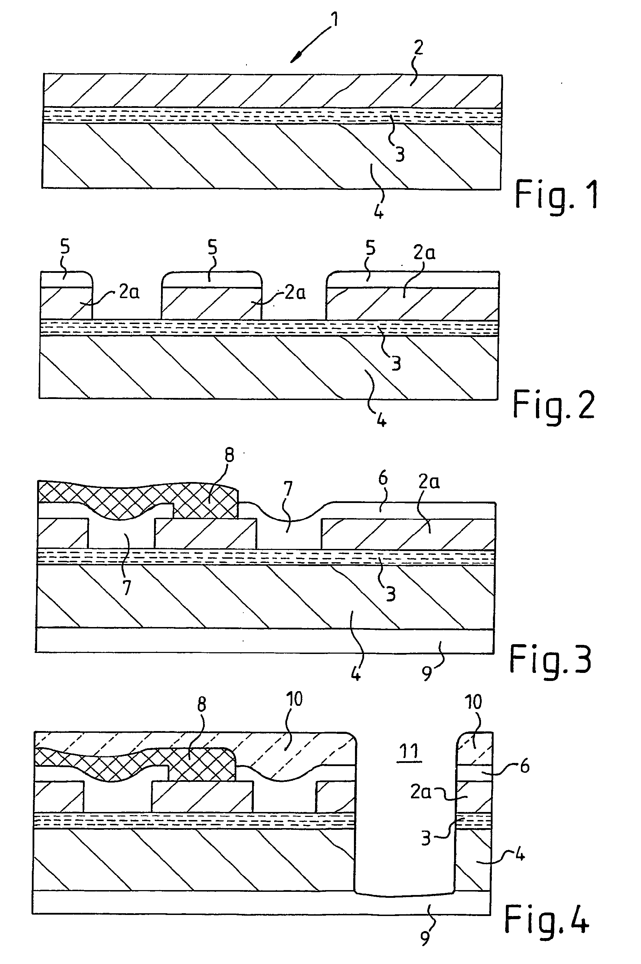

Das Schnittbild nach Figur 4 ergibt sich nach folgenden weiteren Prozessschritten:

Auf den Schichtaufbau wurde eine PECVD-Schutzoxidschicht 10 aufgebracht und über einen Fotolithografieprozessschritt die Bereiche definiert, an denen durch den Wafer 1 hindurch ein "Trench" (Ätzgraben) geätzt werden soll. Für das Ätzen eines Trench 11 können übliche "Trenchprozesse" eingesetzt werden. Im vorliegenden Beispiel wurde der Trench 11 durch den Schichtaufbau dünnes Schutzoxid 10, Fülloxid 6, Funktionssilizium 2a, dünnes SOI-Oxid 3 und dickes Bulksilizium 4 hindurchgeätzt. Es verbleibt ein "Tief-Trench" 11 durch den Wafer 1, der jedoch an der Germanium-Schicht 9 endet, weil dort der Ätzprozess durch die Detektion der Germaniumschicht im Ätzprozess abgebrochen wurde.

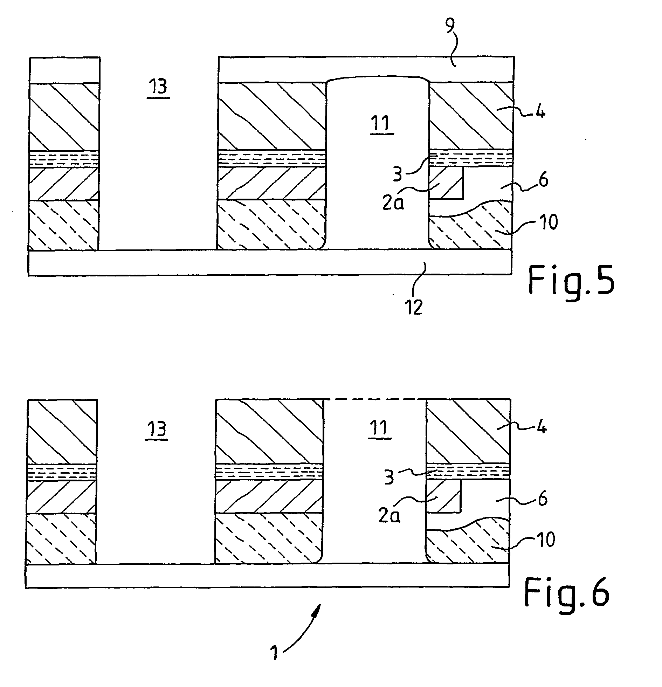

In Figur 5 ist der zum Sägen auf "Blue-Tape" 12 fixierte Wafer mit einer bereits gesägten Sägestraße 13 abgebildet. Der Wafer 1 wurde hierfür mit der Vorderseite auf dem "Blue-Tape" fixiert.

Figur 6 zeigt das Prozessstadium bei entfernter Germaniumschicht 9. Hierfür kann z.B. eine Wasserstoffperoxid-Lösung beispielsweise in der Art eines Sprühentwicklers zum Einsatz kommen. Nach dem Entfernen der Germaniumschicht können dann die einzelnen auf dem Wafer entstandenen Bauelemente durch Entnehmen vom "Blue-Tape" 12 vereinzelt werden.

## Patentansprüche

1. Verfahren zum Vereinzeln von auf Silizium bzw. einem Schichtaufbau Silizium/Isolator basierenden Bauteilen, wobei eine germaniumhaltige Schicht und/oder eine Germaniumschicht (9) an einer Stelle in einem Substrat vorgesehen wird, an welcher oder in deren Umgebung ein Ätzvorgang beendet werden soll, wobei durch den Ätzvorgang auf einer Vorderseite des Substrates Ätzgräben (11) erzeugt werden und während des Ätzvorganges eine Detektion auf Germanium ätzprodukte durchgeführt wird und bei Detektion von Germanium und/oder Germaniumverbindungen der Ätzvorgang abgebrochen wird, **dadurch gekennzeichnet, dass** die Germanium- und/oder germaniumhaltige Schicht (9) auf einer Rückseite des Substrates aufgebracht wird und nach Beendigung des Ätzvorganges entfernt wird zur Separierung von Einzelbauteilen entsprechend der Ätzgräben (11).

2. Verfahren nach Anspruch 1, **dadurch gekennzeichnet, dass** die Germanium- und/oder germaniumhaltige Schicht (9) mittels CVD (Chemical Vapor Deposition), insbesondere PECVD (Plasma Enhanced Chemical Vapor Deposition),oder mittels Sputtern erzeugt wird.

3. Verfahren nach Anspruch 1 oder 2, **dadurch gekennzeichnet, dass** die Germanium- und/oder germaniumhaltige Schicht (9) mittels Wasserstoffperoxid oder wasserstoffperoxidhaltigen Ätzlösungen, insbesondere in der Art eines Sprühentwicklers, entfernt wird.

4. Verfahren nach einem der vorhergehenden Ansprüche, **dadurch gekennzeichnet, dass** Germanium und/oder Germaniumverbindungen mit optischer Emissionsspektroskopie oder Massenspektroskopie detektiert werden.

5. Verfahren nach einem der vorhergehenden Ansprüche, **dadurch gekennzeichnet, dass** vor der Entfernung der Germanium- und/oder germaniumhaltigen Schicht (9) das Substrat mit der Vorderseite auf einer Folie fixiert wird.

6. Verfahren nach Anspruch 5, **dadurch gekennzeichnet, dass** vor der Entfernung der Germanium- und/oder germaniumhaltigen Schicht (9) das Substrat zur Erzeugung von Sägestraßen (13) gesägt wird.

7. Verfahren nach Anspruch 5 oder 6, **dadurch gekennzeichnet, dass** nach der Entfernung der Germanium- und/oder germaniumhaltigen Schicht (9) die Einzelbauelemente der Folie entnommen werden.

## Claims

1. Method for singulating devices based on silicon or a silicon/insulator layer construction, wherein a germanium-containing layer and/or a germanium layer (9) are/is provided at a location in a substrate at which or in the vicinity of which an etching process is intended to be ended, wherein etching trenches (11) are produced by the etching process on a front side of the substrate and a detection with regard to germanium etching products is carried out during the etching process and the etching process is terminated upon detection of germanium and/or germanium compounds, **characterized in that** the germanium and/or germanium-containing layer (9) are/is applied on a rear side of the substrate and removed after the end of the etching process in order to separate individual devices in accordance with the etching trenches (11).

2. Method according to Claim 1, **characterized in that** the germanium and/or germanium-containing layer (9) are/is produced by means of CVD (chemical vapour deposition), in particular PECVD (plasma enhanced chemical vapour deposition), or by means of sputtering.

3. Method according to Claim 1 or 2, **characterized in that** the germanium and/or germanium-containing layer (9) are/is removed by means of hydrogen peroxide or hydrogen-peroxide-containing etching solutions, in particular in the manner of a spray developer.

4. Method according to any of the preceding claims, **characterized in that** germanium and/or germanium compounds are/is detected by optical emission spectroscopy or mass spectroscopy.

5. Method according to any of the preceding claims, **characterized in that** before the removal of the germanium and/or germanium-containing layer (9), the substrate is fixed by the front side on a film.

6. Method according to Claim 5, **characterized in that** before the removal of the germanium and/or germanium-containing layer (9), the substrate is sawn in order to produce sawing channels (13).

7. Method according to Claim 5 or 6, **characterized in that** after the removal of the germanium and/or germanium-containing layer (9), the individual components are taken from the film.

## Revendications

1. Procédé pour séparer un à un des composants à base de silicium ou d'une structure stratifiée de silicium et d'isolant, dans lequel une couche contenant du germanium et/ou une couche (9) de germanium est prévue en un emplacement d'un substrat sur lequel ou au voisinage duquel une opération de gravure doit se terminer,
l'opération de gravure formant des rainures gravées (11) sur le côté avant du substrat et les produits de gravure du germanium étant détectés pendant l'opération de gravure, l'opération de gravure étant interrompue en cas de détection du germanium et/ou du composé de germanium,
**caractérisé en ce que**
la couche (9) en germanium ou contenant du germanium est appliquée sur le côté arrière du substrat et est enlevée lorsque l'opération de gravure est terminée, pour séparer les différents composants en correspondance aux rainures gravées (11).

2. Procédé selon la revendication 1, **caractérisé en ce que** la couche (9) en germanium et/ou contenant du germanium est formée par CVD ("Chemical Vapor Déposition" - dépôt chimique de vapeur), en particulier par PECVD ("Plasma Enhanced Chemical Vapor Deposition"
- dépôt chimique de vapeur renforcé par plasma) ou par pulvérisation.

3. Procédé selon les revendications 1 ou 2, **caractérisé en ce que** la couche (9) en germanium et/ou contenant du germanium est enlevée au moyen de peroxyde d'hydrogène ou d'une solution de gravure contenant du peroxyde d'hydrogène, en particulier par un développeur à aspersion.

4. Procédé selon l'une des revendications précédentes, **caractérisé en ce que** l'on y détecte le germanium et/ou les composés de germanium par spectroscopie à émission optique ou par spectroscopie de masse.

5. Procédé selon l'une des revendications précédentes, **caractérisé en ce qu'**avant d'enlever la couche (9) en germanium et/ou contenant du germanium, le substrat est fixé sur une feuille par son côté avant.

6. Procédé selon la revendication 5, **caractérisé en ce qu'**avant d'enlever la couche (9) en germanium et/ou contenant du germanium, le substrat est scié de manière à former des pistes sciées (13).

7. Procédé selon les revendications 5 ou 6, **caractérisé en ce que** les différents composants sont retirés de la feuille après l'enlèvement de la couche (9) en germanium et/ou contenant du germanium.
